(19) Europäisches Patentamt
European Patent Office
Office européen des brevets

(11) **EP 1 884 831 A2**

(12) **EUROPÄISCHE PATENTANMELDUNG**

(43) Veröffentlichungstag:
**06.02.2008 Patentblatt 2008/06**

(51) Int Cl.:
***G03F 7/20*** *(2006.01)*

(21) Anmeldenummer: 07012914.3

(22) Anmeldetag: **02.07.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **02.08.2006 DE 102006036064**

(71) Anmelder: **Carl Zeiss SMT AG**
**73447 Oberkochen (DE)**

(72) Erfinder:
• **Endres, Martin**
**89551 Königsbronn (DE)**
• **Ossmann, Jens**
**73430 Aalen (DE)**

(74) Vertreter: **Sawodny, Michael-Wolfgang**
**Dreiköniggasse 10**
**89073 Ulm (DE)**

(54) **Beleuchtungssystem für eine Projektionsbelichtungsanlage mit Wellenlängen < 193 nm**

(57) Die Erfindung betrifft ein Beleuchtungssystem für eine Projektionsbelichtungsanlage mit Wellenlängen ≤ 193nm, bevorzugt ≤ 126 nm, besonders bevorzugt EUV-Wellenlängen, wobei das Licht einer Lichtquelle in eine Feldebene (129) geleitet wird, umfassend ein optisches Element (102) mit einer Vielzahl von Feldrasterelementen (309), das in einer Ebene (150) in einem Lichtweg von der Lichtquelle (101) zur Feldebene (129) nach der Lichtquelle (101) angeordnet ist, wobei in der Ebene (150) eine Ausleuchtung zur Verfügung gestellt wird und wenigstens ein Teil der Vielzahl von Feldrasterelementen (309) in der Ebene (150) nicht vollständig ausgeleuchtet wird und eine Vorrichtung zur Einstellung der Ausleuchtung der nicht vollständig ausgeleuchteten Feldrasterelemente vorgesehen ist, mit der eine Uniformität eines ausgeleuchteten Feldes (131) in der Feldebene (129) eingestellt werden kann.

Fig.3

EP 1 884 831 A2

**Beschreibung**

**Gebiet der Erfindung**

Die Erfindung betrifft ein Beleuchtungssystem für eine Projektionsbelichtungsanlage mit Wellenlängen ≤ 193 nm, bevorzugt ≤ 126 nm, insbesondere ≤ 100 nm sowie eine Projektionsbelichtungsanlage und ein Verfahren zur Einstellung der Uniformität einer Ausleuchtung in einer Feldebene sowie der Elliptizität und Telezentrie einer Ausleuchtung in einer Austrittspupille.

**Stand der Technik**

Beleuchtungssysteme für die Mikrolithographie mit Wellenlängen $\lambda$ ≤193 nm sind aus einer Vielzahl von Publikationen bekannt geworden.

Um die Strukturbreite von elektronischen Komponenten, insbesondere in den sub-$\mu$m-Bereich reduzieren zu können, ist es vorteilhaft, die Wellenlängen des eingesetzten Lichtes zu reduzieren. Hier bietet sich die Verwendung von Licht mit Wellenlängen ≤193 nm, insbesondere eine Lithographie mit weichen Röntgenstrahlen, die sog. EUV-Lithographie an.

Bei der EUV-Lithographie werden derzeit Wellenlängen von 10 bis 30 nm, insbesondere im Bereich 11 bis 14 nm diskutiert, insbesondere eine Wellenlänge $\lambda$ von 13,5 nm. Die Bildqualität in der EUV-Lithographie wird auf der einen Seite durch das Projektionsobjektiv und auf der anderen Seite durch das Beleuchtungssystem bestimmt. Das Beleuchtungssystem soll in einer Feldebene, in der eine strukturtragende Maske, das sog. Retikel, angeordnet sein kann, ein Feld bspw. ein Ringfeld so gleichmäßig wie möglich ausleuchten. Mit Hilfe des Projektionsobjektives wird ein Feld in einer Feldebene in eine Bildebene, die auch als Wafer-Ebene bezeichnet wird, abgebildet. In der Bildebene ist ein lichtsensitives Objekt bspw. ein Wafer angeordnet.

Bei Systemen, die mit EUV-Licht arbeiten, sind die optischen Elemente als reflektive optische Elemente, insbesondere als Spiegel ausgebildet. Die Gestalt des Feldes in der Feldebene eines EUV-Beleuchtungssystems ist typischerweise die eines Ringfeldes.

Projektionsbelichtungsanlagen, in denen die Beleuchtungssysteme wie in der Erfindung verwandt werden, werden normalerweise im sog. Scanning Modus betrieben. Beleuchtungssysteme für die EUV-Lithographie sowie Projektionsbelichtungsanlagen mit derartigen Beleuchtungssystemen sind aus der US-B-6,452,661, der US-B-6,198,793 oder der US-B-6,438,199 bekannt geworden. Die zuvor genannten EUV-Beleuchtungssysteme umfassen sog. Wabenkondensoren zur Einstellung der Etendue und zur Erreichung einer homogenen Ausleuchtung des Feldes in der Feldebene und einer wohldefinierten Ausleuchtung einer Pupille in der Pupillenebene. Die Wabenkondensoren umfassen in der Regel zwei facettierte optische Elemente, ein erstes facettiertes optisches Element mit einer Vielzahl von Feldrasterelementen und ein zweites facettiertes optisches Element mit einer Vielzahl von Pupillenrasterelementen.

Aus der WO 2002/27401 ist ein doppelt facettiertes Beleuchtungssystem bekannt geworden, bei dem nur weitgehend vollständig ausgeleuchtete Feldrasterelemente in die Feldebene abgebildet werden.

Aus der US 6,771,352 ist ein Beleuchtungssystem bekannt geworden, bei dem mittels Blenden einzelne Feldrasterelemente vollständig abgeblendet werden können. Auch das teilweise Abblenden eines Feldrasterelementes ist in der US 6,771,352 gezeigt, allerdings sind die aus der US 6,771,352 hierfür bekannten Blenden stets teilweise lichtdurchlässig. Dies hat den Nachteil, dass eine scharfe Grenze zwischen dem belichteten Teilbereich und dem nicht belichteten Teilbereich eines Feldrasterelementes nicht ausgebildet wird.

Eine scharfe Grenze ist insbesondere dann von Vorteil, wenn die zu korrigierende Uniformität starke Schwankungen aufweist. Durch gezielte Positionierung der Grenze kann ein relativ starker Korrektureinfluss in einem ganz bestimmten Bereich bzw. an einer ganz bestimmten Stelle des Feldes ausgeübt werden an die die Grenze abgebildet wird. Starke Variationen in der Uniformität treten zum Beispiel auf, wenn die Ausleuchtung der Feldrasterelemente starke örtlich begrenzte Variationen aufweist. Diese können beispielsweise aufgrund von Schatten, die die Speichen eines im Lichtweg vor dem optischen Element mit Feldrasterelementen angeordneten Kollektors werfen, auftreten. Ein Kollektor mit Speichen zur Halterung der einzelnen Kollektorschalen ist beispielsweise in der EP 1354325 offenbart.

Aus der WO 2005/015314 ist ein doppelt facettiertes Beleuchtungssystem bekannt geworden, bei dem zur Verbesserung der Uniformität der Ausleuchtung eines Feldes in einer Feldebene Abschwächer, insbesondere Filterelemente in oder nahe einer zur Feldebene konjugierten Ebene angeordnet sind. Die Filterelemente sind gemäß der WO 2005/015314 den einzelnen Facetten des ersten facettierten Elementes zugeordnet. Auf diese Weise ist es möglich, die Lichtintensität in jedem einzelnen Lichtkanal, der einer Facette des ersten facettierten Elementes zugeordnet ist, zu beeinflussen.

**Zusammenfassung der Erfindung**

Nachteilig am aus der WO 2005/015314 bekannten System war die aufwendige Konstruktion. Ein weiterer Nachteil an den zuvor beschriebenen Systemen gemäß dem Stand der Technik war, dass zur Erzielung einer möglichst homogenen, d. h. uniformen Ausleuchtung in der Feldebene nur weitgehend vollständig ausgeleuchtete Feldrasterelemente wie in der WO 02/27401 beschrieben, abgebildet werden. Bei einer kreisförmigen Ausleuchtung führt dies aber dazu, dass 20 % oder mehr des von der Lichtquelle in die Ebene, in der die Feldrasterelemente angeordnet sind, abgestrahlten Lichtes vom Beleuchtungssystem nicht genutzt werden konnten.

Nachteilig an der US 6,400,794 bei der auch halb ausgeleuchtete Facetten verwendet wurden, waren die Telezentrie- und Elliptizitätsfehler in der Austrittspupille des Beleuchtungssystems.Bei einem doppelt-facettierten Beleuchtungssystem wird zwischen einem Feldrasterelement und einem Pupillenrasterelement durch Zuordnung ein Lichtkanal ausgebildet. Eine inhomogene Ausleuchtung des ersten facettierten optischen Elementes mit Feldrasterelementen führt daher zu einer inhomogenen Ausleuchtung des zweiten facettierten optischen Elements mit Pupillenrasterelementen. Diese inhomogene Ausleuchtung hat die oben beschriebenen Telezentrie- und Elliptizitätsfehler zur Folge. Im Stand der Technik sind somit Beleuchtungssysteme gezeigt, bei denen entweder die Ausnutzung des von einer Lichtquelle abgestrahlten Lichtes unzureichend ist, oder aber zu große Telezentrie- bzw. Elliptizitätsfehler auftreten.

Unter einer uniformen Ausleuchtung in der Feldebene eines Beleuchtungssystems wird in vorliegender Anmeldung verstanden, dass der Unterschied ∆SE von minimaler und maximaler scanintegrierter Energie, der sog. Uniformitätsfehler über der Feldhöhe einen gewissen Wert unterschreitet. Für den Uniformitätsfehler ∆SE in Prozent gilt:

$$\Delta SE = \frac{SE(\max) - SE(\min)}{SE(\max) + SE(\min)} \bullet 100 \ [\%]$$

Unter Telezentriefehler in vorliegender Anmeldung die Abweichung des Durchstoßpunktes des Schwerpunktstrahles in der Austrittspupillenebene von der Mitte einer bspw. kreisförmigen Austrittspupille verstanden.

Unter Elliptizität wird die Gewichtung der Energieverteilung in der Austrittspupille verstanden. Ist die Energie in der Austrittspupille über den Winkelbereich gleichverteilt, so hat die Elliptizität einen Wert von 1. Der Elliptizitätsfehler bezeichnet die Abweichung der Elliptizität vom idealen Wert der Gleichverteilung, nämlich dem Wert 1.

Aufgabe der Erfindung ist es die Nachteile des Standes der Technik zu überwinden, insbesondere ein Beleuchtungssystem für Wellenlängen ≤ 193nm anzugeben, das sich durch geringe Uniformitäts-, Elliptizitäts- und Telezentrie-Fehler auszeichnet, bei gleichzeitig möglichst geringen Lichtverlusten, d.h. die Eigenschaften geringe Uniformitäts-, Elliptizitäts- und Telezentriefehler mit einer hohen Lichtausbeute verbindet.

Erfindungsgemäß wird die Aufgabe durch ein Beleuchtungssystem mit einer Lichtquelle, die Strahlung mit einer Wellenlänge ≤ 193nm emittiert gelöst, wobei das Beleuchtungssystem eine erste facettierte optische Komponente mit Feldrasterelementen in einer Ebene umfasst, in der eine erste Ausleuchtung zur Verfügung gestellt wird, wobei wenigstens ein Teil der Feldrasterelemente in der Ebene nicht vollständig ausgeleuchtet werden und eine Vorrichtung zur Einstellung der Ausleuchtung der nicht vollständig ausgeleuchteten Feldrasterelemente vorgesehen ist mit der eine Uniformität einer zweiten Ausleuchtung eines Feldes in einer Feldebene eingestellt werden kann. Unter nicht vollständig wird in vorliegender Anmeldung verstanden, dass die Fläche eines Rasterelementes bevorzugt zu weniger als 95 %, insbesondere zu weniger als 90%, ganz besonders bevorzugt zu weniger als 85%, insbesondere zu weniger als 80%, insbesondere bevorzugt zu weniger als 75% ausgeleuchtet wird. Bei einer nicht vollständig ausgeleuchteten Feldfacette bzw. einem nicht vollständig ausgeleuchteten Feldrasterelement wird nur ein erster Teilbereich der Feldfacette beleuchtet. Gemäß der Erfindung wird beispielsweise durch eine Blende das Licht geblockt, so dass ein zweiter Teilbereich des Feldrasterelementes praktisch kein Licht aufnimmt, d. h. weitgehend vollständig vom Licht abgeschirmt wird. Wird beispielsweise ein Feldrasterelement zu 50% ausgeleuchtet, so umfasst der erste, ausgeleuchtete Teilbereich 50% der Gesamtfläche des Feldrasterelementes und der zweite, nicht ausgeleuchtete Teil und damit dunkle Teil des Feldrasterelementes ebenfalls 50% der Gesamtfläche des Feldrasterelementes.

Insbesondere stellt die Erfindung ein Beleuchtungssystem für eine Projektionsbelichtungsanlage mit Wellenlängen ≤ 193nm, bevorzugt ≤ 126 nm, besonders bevorzugt Wellenlängen ≤ 30 nm, insbesondere im Bereich 10 nm bis 30 nm wobei das Licht einer Lichtquelle in einem Lichtweg in eine Feldebene geleitet wird zur Verfügung, die ein optisches Element mit einer Vielzahl von Feldrasterelementen, das in einer Ebene in einem Lichtweg von der Lichtquelle zur Feldebene nach der Lichtquelle angeordnet ist, umfasst, wobei in der Ebene eine Ausleuchtung zur Verfügung gestellt wird und wenigstens ein Feldrasterelement der Vielzahl von Feldrasterelementen in der Ebene nur in einem ersten Teilbereich ausgeleuchtet wird und einem zweiten Teilbereich nicht ausgeleuchtet wird und eine Vorrichtung zur Einstellung der Größe des ersten und des zweiten Teilbereichs des Feldrasterelementes vorhanden ist, wobei mit der Vorrichtung eine Uniformität einer Feldausleuchtung eines Feldes in der Feldebene eingestellt werden kann.

Da bei der erfindungsgemäßen Vorrichtung nur die Ausleuchtung der teilweise ausgeleuchteten Feldfacetten geändert wird um die Uniformität einzustellen, ist die mechanische Konstruktion sehr einfach. So reichen bspw. Blenden aus, die am Rand befestigt werden, so dass keine mechanischen Komponenten in den Strahlengang hineinragen und zu Abschattungen führen. Weiterhin ermöglicht das Blendensystem auch eine Hinzunahme von Licht aus dem Strahlengang.

Besonders bevorzugt ist es, wenn der Uniformitätsfehler besser als $\pm$ 5% insbesondere besser als $\pm$ 2% insbesondere besser als $\pm$ 0,5% ist und/oder die scanintegrierte Elliptizität in Abhängigkeit von der x-Position, d.h. der Feldhöhe in einem auszuleuchtenden Feld im Bereich 1 $\pm$ 0,1, insbesondere 1 $\pm$ 0,05, insbesondere 1$\pm$0,02 liegt. Des Weiteren ist es vorteilhaft, wenn sich das System durch einen geringen Telezentrie-Fehler auszeichnet, der in Abhängigkeit von der Position im Feld, d.h. der Feldhöhe einen Fehler von $\pm$ 2,5mrad insbesondere $\pm$ 1,5mrad insbesondere $\pm$ 0,5 mrad, nicht übersteigt. Bevorzugt soll die Energie der Lichtquelle die in die Ebene, in der die Feldrasterelemente angeordnet sind auftrifft, von den Feldrasterelementen zu mehr als 70 %, insbesondere mehr als 80 %, ganz besonders mehr als 90 % aufgenommen werden.

Bevorzugt weist das Feld in der Feldebene eine erste Form auf und die Feldrasterelemente eine zweite Form und die erste Form stimmt weitgehend mit der zweiten Form überein. Wenn die Form des Feldes kreisbogenförmig ist, weisen bevorzugt auch die Feldrasterelemente eine bogenförmige Form auf, wie bspw. in der US 6,195,201 beschrieben.

Wenn die Feldrasterelemente die Form des auszuleuchtenden Feldes aufweisen, können die Feldrasterelemente auf einer Trägerstruktur des facettierten optischen Elementes in Spalten und Reihen angeordnet sein, wobei die Reihen bevorzugt nicht gegeneinander verschoben sind, um eine dichte Packung der bogenförmigen Facetten, wie in der US 6,452,661 beschrieben, zu ermöglichen.

Sind die Feldrasterelemente in Spalten und Reihen angeordnet, so ist es vorteilhaft, wenn mehrere Feldrasterelemente zu Blöcken zusammengefasst sind.

Bevorzugt umfasst die Vorrichtung zur Einstellung der Ausleuchtung wenigstens eine Blende, wobei die Blende bevorzugt einem Feldrasterelement, das nicht vollständig ausgeleuchtet ist, zugeordnet ist. Alternativ ist es möglich, dass einer Blende mehrere Feldfacetten zugeordnet sind, insbesondere, wenn die Feldfacetten und damit die zugehörigen Blenden von den Abmessungen sehr klein sind.

Wird das Beleuchtungssystem in einer Scanning-Projektionsbelichtungsanlage eingesetzt, so weist das Feld eine ausgezeichnete Richtung, nämlich eine Scanrichtung auf, die auch als y-Richtung bezeichnet wird. Die Blende bzw. die Blenden wird bzw. werden dann im Wesentlichen senkrecht zur Scanrichtung beweglich ausgebildet. Durch Verfahren der Blende(n) im Wesentlichen senkrecht zur Scanrichtung d. h. in x-Richtung kann in Abhängigkeit von der Feldhöhe x gezielt Licht, d. h. Energie aus dem Feld herausgenommen oder zugegeben werden. Hierdurch kann die Uniformität der Ausleuchtung in der Feldebene in Abhängigkeit von der Feldhöhe beeinflusst werden.

Alternativ zu Blenden kann die Vorrichtung zur Einstellung der Ausleuchtung auch eine Vielzahl von Drähten aufweisen um Licht abzuschwächen. Ein derartiger Lichtabschwächer ist bspw. in der EP 1291721 gezeigt. Wird eine Einstellung mit Drähten vorgenommen, so werden die Drähte bspw. verschoben, so dass die Schatten der Drähte bestimmte Bereiche auf den Feldfacetten abschatten. Weitere Vorrichtungen zur Einstellung der Ausleuchtung sind bspw. Vorrichtungen mit denen ein beliebiges optisches Element, das im Strahlengang von der Lichtquelle zur Feldebene angeordnet ist, verformt und/oder verkippt werden kann. Mögliche Elemente sind ein Kollektor oder ein Spektralfilter oder ein zusätzlicher Spiegel. Eine weitere Möglichkeit sind Blenden die im Lichtweg von der Lichtquelle zur Feldebene hinter dem Kollektor, d. h. an der Ausgangsseite des Kollektors angeordnet sind. Zur Änderung der Ausleuchtung der teilweise ausgeleuchteten Feldfacetten kann auch das gesamte optische Element mit Feldfacetten, d. h. die Feldfacettenplatte verschoben werden.

Durch die verfahrbare Einstellvorrichtung wie bspw. die Blenden, die den einzelnen Feldfacetten zugeordnet sein können, kann ein Uniformitätsfehler der Feldausleuchtung $\Delta SE \leq 10\%$, erreicht werden, insbesondere ein Uniformitätsfehler $\Delta SE \leq 5\%$, insbesondere $\leq 2\%$. Dieser noch verbleibende Uniformitätsfehler von beispielsweise 2% wird im Wesentlichen durch Degradation der Beschichtungen im Betrieb, thermale Verformungen von optischen Komponenten, oder Austausch von optischen Komponenten bzw. der Lichtquelle verursacht.

Ein Vorteil der Erfindung liegt insbesondere darin, dass es mit Hilfe der Einstellvorrichtung möglich ist, die Uniformität des Beleuchtungssystems stets so einzustellen, dass ein vorgegebener Uniformitätsfehler nicht überschritten wird, auch wenn sich die Ausleuchtung in der Feldebene aufgrund von Änderungen im Beleuchtungssystem zeitlich ändert Dies kann beispielsweise dann der Fall sein, wenn sich die Ausleuchtung aufgrund von räumlichen und zeitlichen Lageänderungen der Lichtquelle ändert. Die räumliche und/oder zeitliche Änderung der Lage bzw. der Abstrahlintensität der Lichtquelle wird auch als "Jitter" der Lichtquelle bezeichnet. Mit Hilfe der erfindungsgemäßen Ausgestaltung ist es also möglich ohne Umbau von Teilen des Systems stets einen vorgegebenen Uniformitätsfehler zu erreichen, in dem die Ausleuchtung der teilweise ausgeleuchteten Bereiche von einem oder mehreren Feldrasterelementen eingestellt wird.

Ferner kann auch eine Veränderung der spektralen Intensitätsverteilung der Lichtquelle zu einer veränderten Ausleuchtung führen. So ist die Reflektivität einer optischen Komponente üblicherweise abhängig von der Wellenlänge des eingestrahlten Lichtes. Daher führt eine Veränderung dieser Wellenlänge zu einer veränderten Reflektivität und somit zu einer Änderung der Ausleuchtung.

Auch der Tausch der Lichtquelle oder eines optischen Elementes im Beleuchtungsstrahlengang kann zu einer geänderten Ausleuchtung, insbesondere einer geänderten Uniformität der Ausleuchtung in der Feldebene führen. Auch ein durch ein Austausch hervorrufender Uniformitätsfehler kann durch die erfindungsgemäße Einrichtung durch gezieltes Abblenden von nur teilweise ausgeleuchteten Feldfacetten korrigiert werden.

Die Ausleuchtung des Beleuchtungssystems kann auch durch eine Degradation der Beschichtung im Betrieb oder durch thermale Verformungen der optischen Komponenten sich ändern. Auch bei einer derartigen Änderung der Ausleuchtung kann der Uniformitätsfehler mit der erfindungsgemäßen Einstellvorrichtung ausgeglichen werden.

Die Erfindung stellt somit ein Beleuchtungssystem zur Verfügung bei dem der Uniformitätsfehler auch bei sich ändernder Ausleuchtung aufgrund bspw. von Tausch von optischen Komponenten, thermischer Verformung von optischen Komponenten, räumlichen und zeitlichen Quellschwankungen mit Hilfe der Einstellvorrichtung ständig unterhalb eines vorgegebenen Uniformitätsfehlers gehalten werden kann. Mit der Erfindung ist es also somit möglich, den Uniformitätsfehler bspw. auch bei zeitlichen Schwankungen der Ausleuchtung jederzeit unter einem bestimmten Grenzwert, beispielsweise unterhalb eines Uniformitätsfehlers von 5%, insbesondere 2% zu halten.

In einer alternativen Ausführungsform der Erfindung sind keine beweglichen Einstellvorrichtungen, wie bspw. Blenden vorgesehen, sondern die Feldrasterelemente, die nicht vollständig ausgeleuchtet werden, sind in der Feldebene auf einer Trägerstruktur des ersten facettierten optischen Elementes derart angeordnet, dass die Feldausleuchtung des Feldes einen bestimmte Uniformitätsfehler im Bereich $\leq 5\%$, insbesondere $\leq 2\%$ aufweist.

Bevorzugt weist die erste Ausleuchtung in der Ebene, in der das erste facettierte optische Element angeordnet ist, eine annulare Form auf.

Besonders bevorzugt ist das Beleuchtungssystem ein doppelt facettiertes Beleuchtungssystem mit einem ersten und einem zweiten facettierten optischen Element, wie bspw. in der US 6,438,199 oder der US 6,198,793 beschrieben. Das zweite facettierte optische Element ist im Lichtweg von der Lichtquelle zur Feldebene nach dem ersten facettierten optischen Element angeordnet. Das zweite facettierte optische Element weist eine Vielzahl von Pupillenrasterelementen auf. Zwischen je einem Feldrasterelement und einem Pupillenrasterelement wird ein Lichtkanal ausgebildet. Da die Anordnung der Pupillenrasterelemente die Lichtverteilung in der Austrittspupille bestimmt, kann durch eine geeignete Zuordnung von nicht vollständig ausgeleuchteten Feldrasterelementen bspw. zu bestimmten, symmetrisch um das Zentrum verteilten Pupillenrasterelementen eine sogenannte Pupillenausleuchtung in der Austrittspupillenebene eingestellt werden, wobei die Pupillenausleuchtung in der Austrittspupillenebene des Beleuchtungssystem eine Telezentrie von besser als $\pm$ 2 mrad, bevorzugt besser als $\pm$ 1 mrad, bevorzugt besser als $\pm$ 0,5mrad aufweist.

In einer besonders bevorzugten Ausführungsform wird die Zuordnung von Feldrasterelementen zu Pupillenrasterelementen so vorgenommen, dass die Pupillenausleuchtung in der Austrittspupille des Beleuchtungssystem eine Elliptizität im Bereich 1 $\pm$ 0,10, bevorzugt 1 $\pm$ 0,05 , bevorzugt 1 $\pm$ 0,025 aufweist.

Neben dem Beleuchtungssystem stellt die Erfindung auch eine Projektionsbelichtungsanlage, die ein Beleuchtungssystem sowie ein Projektionsobjektiv zur Abbildung eines vom Beleuchtungssystem in der Feldebene ausgeleuchteten Objektes in eine Bildebene umfasst, zur Verfügung.

Des Weiteren wird ein Verfahren zur Einstellung der Uniformität, Telezentrie und Elliptizität eines Beleuchtungssystems mit einer Ausleuchtung in einer Ebene, in der ein erstes facettiertes optisches Element mit Feldrasterelementen angeordnet ist und einem Feld in einer Feldebene mit einer Feldausleuchtung sowie einer Pupillenausleuchtung in einer Austrittspupille angegeben. Gemäß dem Verfahren wird die Einstellung der Ausleuchtung in der Ebene in der Feldrasterelementen angeordnet sind derart vorgenommen, dass der Uniformitätsfehler $\Delta$SE der Feldausleuchtung des Feldes $\leq 5\%$, insbesondere $\leq 2\%$ ist. Sodann wird jedem Feldrasterelement ein Pupillenrasterelement eines zweiten optischen Elementes ergebend ein Lichtkanal zugeordnet, wobei die Zuordnung derart erfolgt, dass in einer Austrittspupillenebene eine Pupillenausleuchtung mit einer Telezentrieabweichung von $\pm$ 1 mrad, bevorzugt $\pm$ 0,5 mrad und/oder einer Elliptizität im Bereich 1 $\pm$ 0,1, insbesondere 1 $\pm$ 0,05, insbesondere 1 $\pm$ 0,02 zur Verfügung gestellt wird.

Sämtliche vorgenannte Beleuchtungssysteme zeichnen sich bevorzugt dadurch aus, dass das Licht der Lichtquelle, das in der Ebene des ersten facettierten optischen Elementes in der eine erste Ausleuchtung zur Verfügung gestellt wird, von den Feldrasterelementen zu mehr als 70 %, insbesondere mehr als 80 %, insbesondere mehr als 90 % aufgenommen wird, da auch Feldrasterelemente Licht aufnehmen, die nicht vollständig ausgeleuchtet werden.

Bevorzugt ist die Vorrichtung zur Einstellung der Ausleuchtung ein System aus Blenden, die in einer Richtung senkrecht zur Scanrichtung verfahren werden können.

Um die Zuordnung von Feldrasterelementen zu Pupillenrasterelementen einstellen zu können, können die Feldrasterelemente auf einem Träger unter einem Kippwinkel angeordnet sein, der mit Hilfe von Aktuatoren verändert werden kann. Damit kann dann die Zuordnung von Feldrasterelementen zu Pupillenrasterelementen eingestellt werden.

Die erfindungsgemäße Projektionsbelichtungsanlage eignet sich zur Herstellung mikroelektronischer Bauteile, wobei eine strukturierte Maske auf eine lichtempfindliche Schicht, die sich in der Bildebene eines Projektionsobjektives befindet, abgebildet wird. Das Abbild der strukturierten Maske wird entwickelt ergebend einen Teil des mikroelektronischen Bauteils.

**Beispielhafte Ausführungen der Erfindung**

Nachfolgend soll die Erfindung beispielhaft anhand der Figuren beschrieben werden. Es zeigen:

Fig.1 :          Prinzipschaubild eines doppelt facettierten Beleuchtungssystems
Fig.2a:          der Strahlengang eines doppelt facettierten Beleuchtungssystems bis zur Feldebene
Fig.2b:          der Strahlengang eines doppelt facettierten Beleuchtungssystems bis zur Austrittspupillenebene
Fig.3:           prinzipieller Aufbau eines Beleuchtungssystems
Fig.4a:          erstes facettiertes optisches Element mit Feldrasterelementen gemäß dem Stand der Technik
Fig. 4b:         schematische Ansicht eines ersten facettierten optischen Elementes mit Feldrasterelementen und Blenden gemäß der Erfindung.
Fig. 4c:         detaillierte Ansicht eines ersten facettierten optischen Elementes mit Vorrichtungen zur Einstellung der Ausleuchtung
Fig. 4d:         Einstellung der Ausleuchtung am Beispiel zweier Feldfacetten.
Fig.5            zweites facettiertes optisches Element mit Pupillenfacetten
Fig.6:           ausgeleuchtetes Ringfeld in der Feldebene des Beleuchtungssystemes
Fig. 7:          Aufteilung einer Austrittspupille
Fig. 8:          Beispiel einer Austrittspupille mit Subpupillen.
Fig.9a+b:        Zuordnung von acht teilweise ausgeleuchteten Feldfacetten zu unterschiedlichen Pupillenfacetten ergebend die Austrittspupillenausleuchtung.
Fig.10:          Verlauf der Uniformität für ein Ausführungsbeispiel mit 312 Kanälen, wovon 100 Feldfacetten nicht vollständig ausgeleuchtet sind
Fig.11 a-b:      Verlauf der 0°/90°-Elliptizität bzw. der -45/45°-Elliptizität in Abhängigkeit von der Feldhöhe x vor und nach der Uniformitätskorrektur
Fig.12a-12b:     Verlauf der Telezentrie vor und nach Uniformitätskorrektur

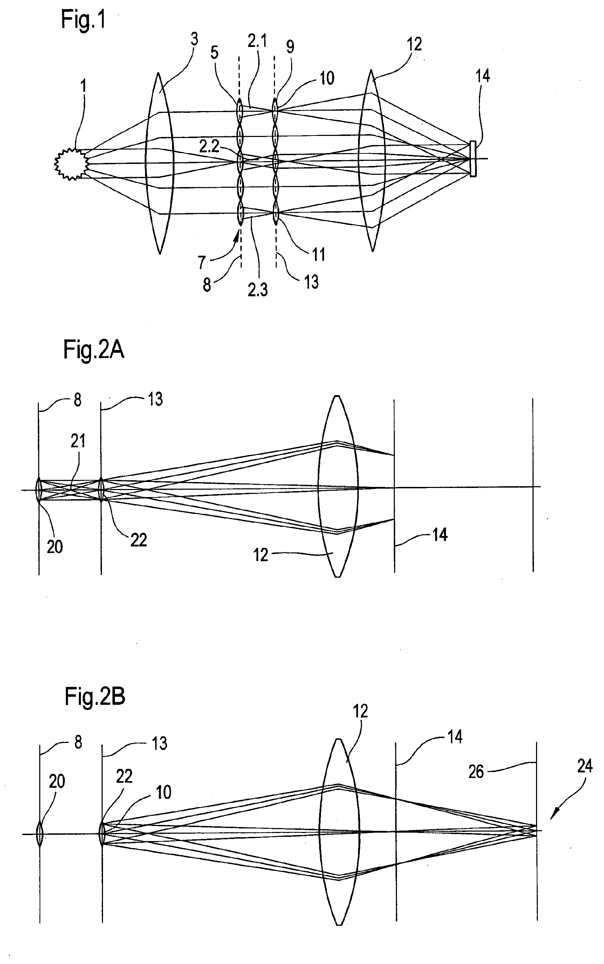

Figur 1 zeigt ein Prinzipschaubild eines Strahlenganges in einem Beleuchtungssystem mit zwei facettierten optischen Elementen, das auch als doppelfacettiertes Beleuchtungssystem bezeichnet wird, in refraktiver Darstellung. Bei Beleuchtungssystemen für EUV-Wellenlängen im Bereich 1 bis 20 nm werden ausschließlich reflektive optische Elemente verwandt, z. B. reflektive Spiegelfacetten als Feldfacetten der ersten facettierten optischen Komponente. Das Licht einer primären Lichtquelle 1 wird mit Hilfe eines Kollektors 3 gesammelt und in ein paralleles oder konvergentes Lichtbüschel konvertiert. Die Feldfacetten bzw. Feldrasterelemente 5 der ersten facettierten optischen Komponente 7 zerlegen das von der Lichtquelle 1 her einfallende Lichtbüschel 2 in eine Vielzahl von Lichtbüscheln 2.1, 2.2 und 2.3 und erzeugen sekundäre Lichtquellen 10 nahe oder am Ort einer zweiten facettierten optischen Komponente 11. Die Ebene, in der die erste facettierte optische Komponente liegt, wird als erste Ebene 8 bezeichnet. In dem gezeigten Beispiel ist die zweite Ebene 13, in der die zweite facettierte optische Komponente liegt und in der in vorliegendem Beispiel auch die sekundären Lichtquellen 10 ausgebildet werden, eine zur Austrittspupillenebene des Beleuchtungssystems konjugierte Ebene. Der Feldspiegel 12 bildet die sekundären Lichtquellen 10 in die Austrittspupille des Beleuchtungssystems (nicht gezeigt) ab, die mit der Eintrittspupille eines nachfolgenden nicht gezeigten Projektionsobjektives übereinstimmt. Die Feldrasterelemente 5 werden durch die Pupillenrasterelemente 9 und das optische Element 12 in die Feldebene 14 des Beleuchtungssystems abgebildet. Bevorzugt ist in der Feldebene 14 des Beleuchtungssystems eine strukturierte Maske, das sogenannte Retikel angeordnet. Nachfolgend soll der Zweck der Feldrasterelemente sowie der Pupillenrasterelemente wie in Fig. 1 gezeigt mit Bezug auf die Fig. 2a und 2b für ein erstes Feldrasterelement 20 und ein erstes Pupillenrasterelement 22, zwischen denen ein Lichtkanal 21 ausgebildet wird, beschrieben werden. Hierbei ist wiederum das erste Feldrasterelement 20 und das Pupillenrasterelement 22 refraktiv dargestellt, ohne Beschränkung hierauf. Vielmehr soll die refraktive Darstellung beispielhaft auch für reflektive Elemente sein.

Das erste Feldrasterelement 20 wird in eine Feldebene 14 des Beleuchtungssystems, in dem ein Feld vorbestimmter Geometrie bzw. Gestalt ausgeleuchtet wird mit Hilfe des ersten Pupillenrasterelements 22 und des optischen Elementes 12 abgebildet. In der Feldebene 14, ist ein Retikel bzw. eine strukturierte Maske angeordnet. Generell bestimmt die geometrische Ausdehnung des Feldrasterelementes 20 die Gestalt des ausgeleuchteten Feldes in der Feldebene.

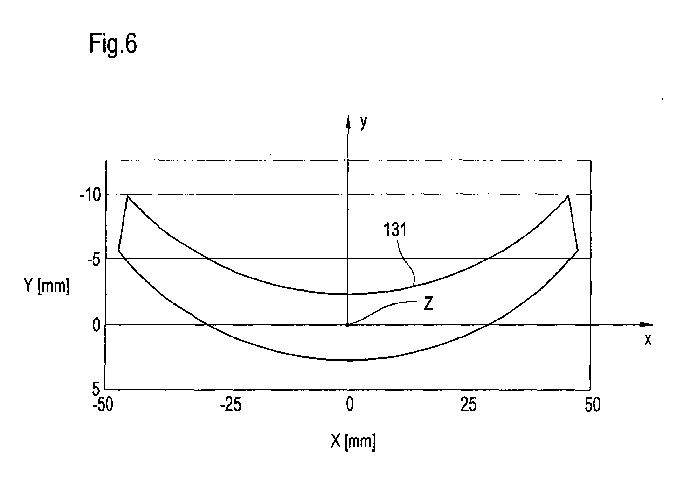

Ein Beispiel für ein ausgeleuchtetes Feld in der Feldebene, wie es beispielsweise in einem Ringfeld-Scanner ausgebildet wird, ist in Figur 6 gezeigt.

In einer ersten Ausführungsform der Erfindung kann vorgesehen sein, dass das Feldrasterelement 20 die Gestalt des Feldes aufweist, also beispielsweise bei einem ringförmigen Feld die Feldrasterelemente ebenfalls eine ringförmige Gestalt aufweisen. Dies ist beispielsweise in den Patentschriften US 6,452,661 oder US 6,195,201 gezeigt, deren Inhalt durch diese Bezugnahme voll umfänglich in die vorliegende Anmeldung mit aufgenommen wurde.

Alternativ hierzu können die Feldrasterelemente rechteckige Gestalt aufweisen. Um das bogenförmige Feld in der Feldebene auszuleuchten, ist es bei rechteckigen Feldrasterelementen erforderlich, dass die rechteckigen Felder in bogenförmige Felder transformiert werden, beispielsweise mit Hilfe eines Feldspiegels, wie beispielsweise in der US 6,198,793 beschrieben.

Bei Systemen mit bogenförmigen Rasterelementen ist ein Feldspiegel zur Ausleuchtung eines Ringfeldes in der Feldebene nicht erforderlich. Das Feldrasterelement 20 ist derart ausgestaltet, dass ein Bild der primären Lichtquelle 1, eine sog. sekundäre Lichtquelle 10 am oder nah des Ortes des Pupillenrasterelementes ausgebildet wird. Um eine zu hohe Wärmelast auf den Pupillenrasterelementen 9 zu vermeiden, können die Pupillenrasterelemente defokussiert zu den sekundären Lichtquellen angeordnet sein.

Die sekundären Lichtquellen weisen aufgrund der Defokussierung eine Ausdehnung auf. Die Ausdehnung kann zudem auch durch die Form der Lichtquelle bedingt sein.

In einer bevorzugten Ausführungsform der Erfindung kann vorgesehen sein, dass die Gestalt der Pupillenrasterelemente an die Gestalt der sekundären Lichtquellen angepasst ist.

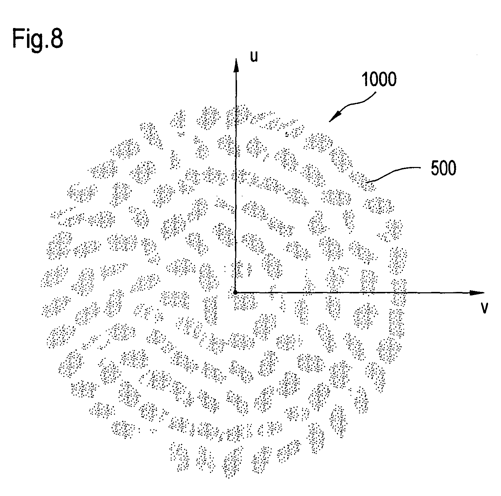

Wie in Figur 2b gezeigt, bildet das optische Element 12, die sekundären Lichtquellen 10 in die Austrittspupillenebene 26 des Beleuchtungssystemes ab, wobei die Austrittspupille in der Austrittspupillenebene 26 mit der Eintrittspupille des Projektionsobjektives zusammenfällt. In der Austrittspupillenebene 26 werden tertiäre Lichtquellen, sog. Subpupillen zu jeder sekundären Lichtquelle ausgebildet. Dies ist in Figur 8 gezeigt.

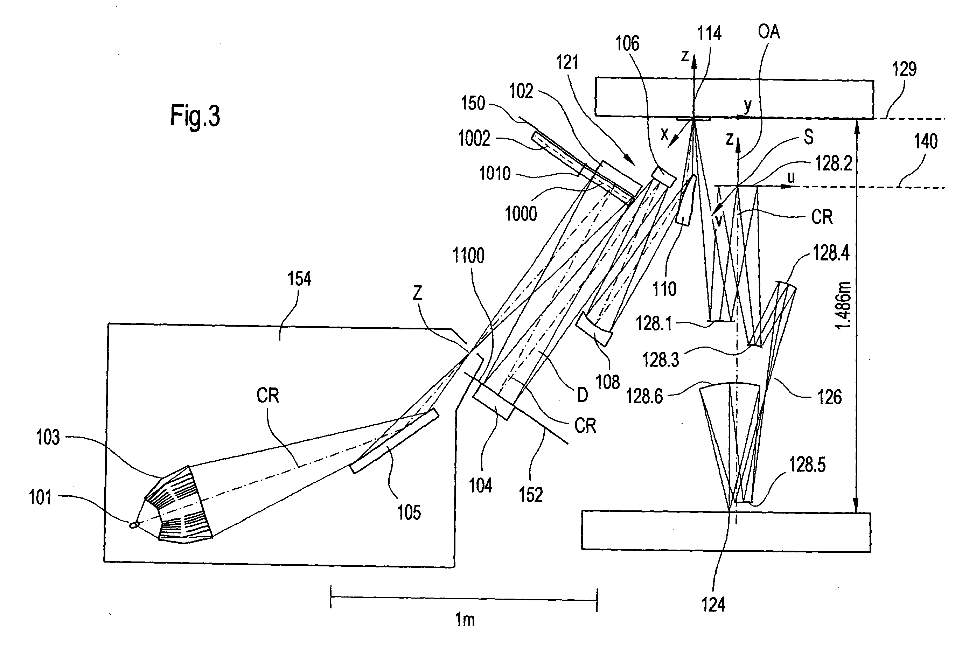

In Figur 3 ist eine Ausgestaltung einer reflektiven Projektionsbelichtungsanlage mit einem erfindungsgemäßen Beleuchtungssystem, wie es für die EUV-Lithographie verwendet wird, schematisiert dargestellt. Sämtliche optischen Komponenten sind katoptrische Elemente, d. h. Spiegel z. B. Feldfacettenspiegel. Das Lichtbüschel der Lichtquelle 101 wird durch einen grazing incidence Kollektorspiegel 103, der vorliegend als genesteter Kollektorspiegel mit einer Vielzahl von Spiegelschalen ausgebildet ist, gebündelt und nach spektraler Filterung an einem Gitterspektralfilterelement 105 in Verbindung mit einem Zwischenbild Z der Lichtquelle auf das erste facettierte optische Element 102 mit Feldrasterelementen gelenkt. Die Lichtquelle 101 der Kollektorspiegel 103 sowie der Gitterspektralfilter 105 bilden eine sogenannte Quelleneinheit 154. Das erste facettierte optische Element 102 mit Feldrasterelementen erzeugt sekundäre Lichtquellen am Ort oder nahe des Ortes des zweiten facettierten optischen Elementes 104 mit Pupillenrasterelementen. Das erste facettierte optische Element 102 ist in einer ersten Ebene 150 und das zweite facettierte optische Element 104 in einer zweiten Ebene 152 angeordnet. Da im Regelfall die Lichtquelle eine ausgedehnte Lichtquelle ist, sind auch die sekundären Lichtquellen ausgedehnt, d. h. dass jede sekundäre Lichtquelle eine vorbestimmte Gestalt aufweist. Wie zuvor beschrieben können die einzelnen Pupillenrasterelemente an die vorbestimmte Gestalt der sekundären Lichtquelle angepasst sein.

Die Pupillenrasterelemente dienen dazu, zusammen mit den optischen Elementen 121 die Feldrasterelemente in eine Feldebene 129 des Beleuchtungssystems, in der auch eine strukturtragende Maske 114 angeordnet sein kann, abzubilden. In der Feldebene wird eine Feldebenenausleuchtung eines Feldes wie z. B. in Figur 6 gezeigt, zur Verfügung gestellt.

Der Abstand D zwischen dem ersten facettierten optischen Element 102 und dem zweiten facettierten optischen Element 104 ist in Figur 3 eingezeichnet und wird entlang des Hauptstrahles CR zum zentralen Feldpunkt Z, der vom ersten optischen Element 102 zum zweiten optischen Element 104 verläuft, definiert.

Jedem Feldrasterelement des ersten facettierten optischen Elementes 102 ist ein Pupillenrasterelement des zweiten facettierten optischen Elementes 104 wie in den Figuren 1 bis 2b dargestellt, zugeordnet. Zwischen jedem Feldrasterelement und jedem Pupillenrasterelement verläuft ein Lichtbüschel vom Feldrasterelement zum Pupillenrasterelement. Die einzelnen Lichtbüschel, die vom Feldrasterelement zum Pupillenrasterelement hin verlaufen, werden als sog. Lichtkanäle bezeichnet.

In Figur 3 ist des Weiteren die Austrittspupillenebene 140 des Beleuchtungssystems gezeigt, die mit der Eintrittspupillenebene des Projektionsobjektives 126 zusammenfällt. Die Austrittspupille ergibt sich aus dem Schnittpunkt S des Hauptstrahles CR zum zentralen Feldpunkt Z des in Figur 6 gezeigten beispielhaften Ringfeldes mit der optischen Achse OA des Projektionssystems 126. In der Austrittspupillenebene 140 wird eine Pupillenausleuchtung erzeugt.

Eine beispielhafte Austrittspupille eines Beleuchtungssystems wie in Figur 3 gezeigt, mit einer Pupillenausleuchtung ist in Figur 8 dargestellt.

Das Projektionssystem bzw. Projektionsobjektiv 126 umfasst in der dargestellten Ausführungsform sechs Spiegel 128.1, 128.2, 128.3, 128.4, 128.5 sowie 128.6. Die strukturierte Maske wird mit Hilfe des Projektionsobjektives in die Bildebene 124 abgebildet, in der ein lichtempfindliches Objekt angeordnet ist.

In Fig. 3 ist in der Feldebene 129 das lokale x,y,z-Koordinatensystem und in der Austrittspupillenebene 140 das lokale u,v,z-Koordinatensystem dargestellt.

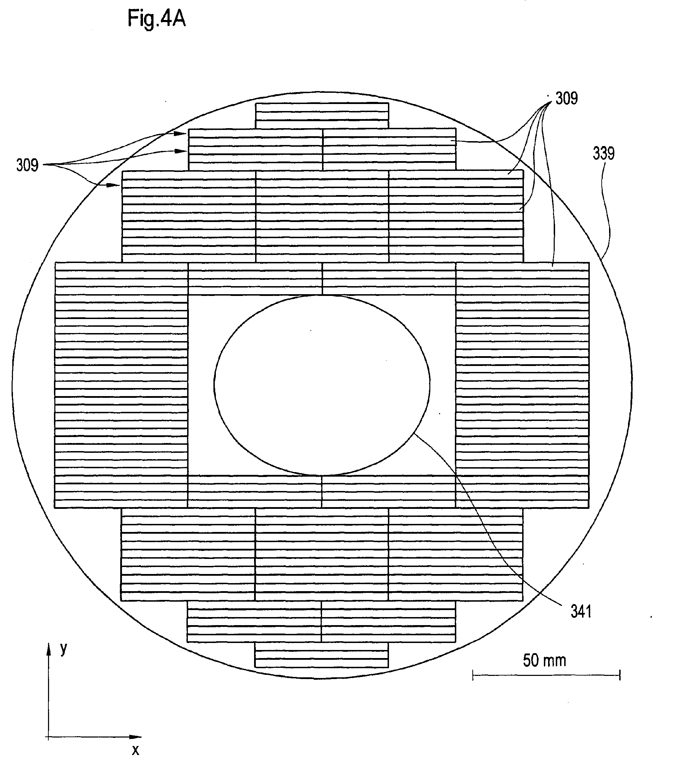

In Figur 4a ist eine zweidimensionale Anordnung von Feldrasterelementen gemäß dem Stand der Technik dargestellt, wobei von der kreisförmigen Ausleuchtung weniger als 70% des von der Lichtquelle her einfallenden Lichtes aufgenommen und zur Ausleuchtung des Feldes in der Feldebene verwandt wird. Die einzelnen reflektiven Feldfacetten 309 sind auf einem ersten facettierten optischen Element, das in Figur 3 mit 102 bezeichnet ist, einer sog. Feldwabenplatte angeordnet. Figur 4a zeigt eine möglich Anordnung von 178 Feldrasterelementen 309 auf einer Feldwabenplatte gemäß dem Stand der Technik. Der Kreis 339 bezeichnet die äußere Ausleuchtungsgrenze einer kreisförmigen Ausleuchtung des ersten optischen Elementes mit Feldrasterelementen 309. Die im Wesentlichen rechteckigen Feldrasterelemente 309 besitzen beispielsweise eine Länge $X_{FRE}$=43,0 mm und eine Breite $Y_{FRE}$ = 4,00 mm. Alle Feldrasterelemente 309 sind innerhalb des Kreises 339 angeordnet und werden daher vollständig ausgeleuchtet. Wie aus Figur 4a hervorgeht wird ein großer Anteil an Licht, der auf den Feldfacettenspiegel auffällt nicht genutzt. Der Kreis 341 bezeichnet die innere Ausleuchtungsgrenze verursacht bspw. durch eine Mittenblende eines genesteten Kollektors.

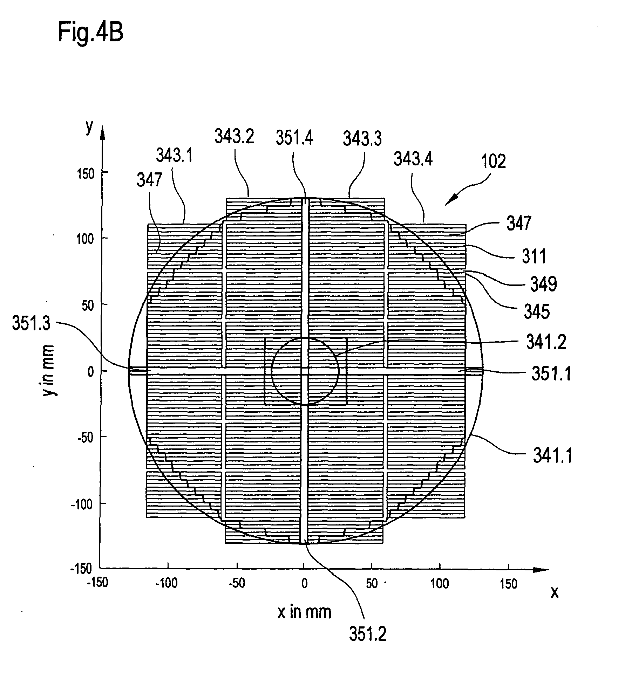

In den Figuren 4b bis 4d sind erfindungsgemäße Anordnungen von ersten facettierten optischen Elementen gezeigt.

Figur 4b zeigt eine Anordnung von insgesamt 312 Feldfacetten auf einem ersten facettierten optischen Element, das in Figur 3 mit der Referenznummer 102 bezeichnet ist. Die einzelnen Feldfacetten sind mit Bezugsziffer 311 bezeichnet. Die Feldwaben der einzelnen Rasterelemente 311 sind auf einer nicht dargestellten Trägerstruktur des ersten facettierten Elementes befestigt. Wie aus Figur 4b zu entnehmen ist, handelt es sich bei der Ausleuchtung der Ebene, in der das erste facettierte optische Element angeordnet ist, um eine annulare Ausleuchtung mit einer äußeren Ausleuchtungsgrenze 341.1 und einer inneren Ausleuchtungsgrenze 341.2. Des Weiteren sind die Rasterelemente in insgesamt vier Spalten 343.1, 343.2, 343.3, 343.4 und einzelne Reihen 345 unterteilt. Die Rasterelemente 311 einzelner Reihen sind in den Spalten direkt untereinander angeordnet im Gegensatz zu der in Figur 4a dargestellten versetzten Anordnung von Feldfacetten in unterschiedlichen Reihen. Des Weiteren sind die einzelnen Facetten in Blöcke 347, die untereinander angeordnet sind, zusammengefasst. Die Blöcke und Spalten sind jeweils durch Freiräume 349 voneinander getrennt. Des Weiteren in Figur 4b dargestellt sind die Schatten 351.1, 351.2, 351.3, 351.4 der Speichen, die die einzelnen Schalen des grazing-incidence Kollektors 103 gemäß Figur 3 halten. Wie aus Figur 4b hervorgeht, wird eine Vielzahl von Feldfacetten nur teilweise ausgeleuchtet. Des Weiteren eingezeichnet ist in Figur 4b das Achskoordinatensystem in x- sowie in y-Richtung. Wie aus Figur 4b hervorgeht weisen die Feldfacetten in der Scanrichtung der Projektionsbelichtungsanlage, die mit der y-Richtung zusammenfällt, wesentlich geringere Abmessungen auf, wie in der x-Richtung, die senkrecht auf der Scanrichtung steht.

Ein Vorteil der Erfindung liegt darin, dass die Feldfacetten in Blöcken angeordnet werden können, die eine einfache Montage zulassen. Die versetzte Anordnung der Feldfacetten wie beim Stand der Technik gemäß Fig. 4a war notwendig, um die kreisrunde Ausleuchtung des Feldfacettenspiegels gut mit vollständig beleuchteten Feldfacetten zu füllen. Nachdem nun auch teilweise beleuchtete Facetten zur Ausleuchtung beitragen, ist dieser Versatz nicht mehr nötig.

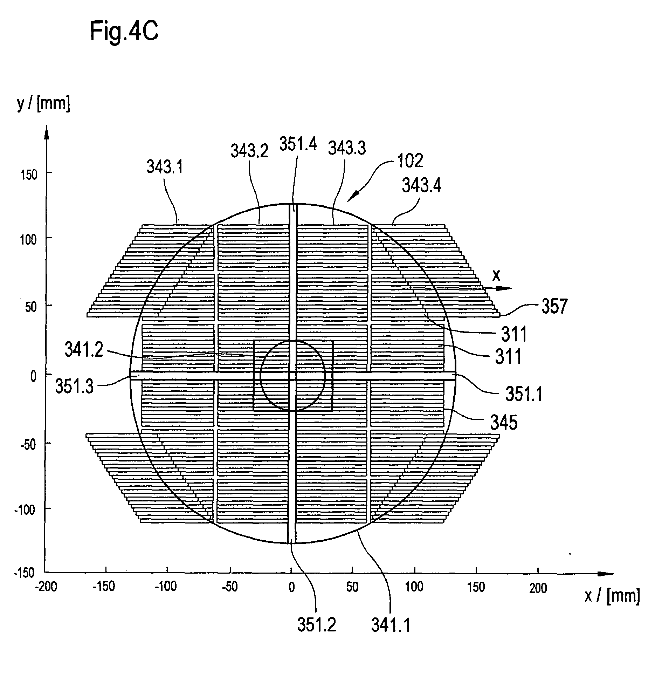

In Figur 4c ist eine erste facettierte optische Komponente 102, die ähnlich zur Figur 4b aufgebaut ist, dargestellt. Gleiche Bauteile sind mit gleichen Bezugsziffern angegeben. Wiederum sind in Figur 4c die einzelnen Rasterelemente 311 in insgesamt 4 Spalten 343.1, 343.2, 343.3, 343.4 und eine Vielzahl von Reihen 345 angeordnet. Des Weiteren weisen die einzelnen Reihen zueinander Abstände auf, insbesondere sind sie derart beabstandet, dass im Bereich der Speichenschatten des grazing-incidence Kollektors keine Feldfacetten angeordnet sind.

Des Weiteren weist die Ausleuchtung eine äußere Berandung 341.1 sowie eine innere Berandung 341.2 auf.

Des Weiteren eingezeichnet sind in Figur 4c für die einzelnen nicht vollständig ausgeleuchteten Feldrasterelemente Blenden 357. Die Blenden 357 sind jeweils einem Feldrasterelement 311 zugeordnet. Die einzelne Blende 357, die einem Feldrasterelement zugeordnet ist, ist in x-Richtung wie eingezeichnet verfahrbar.

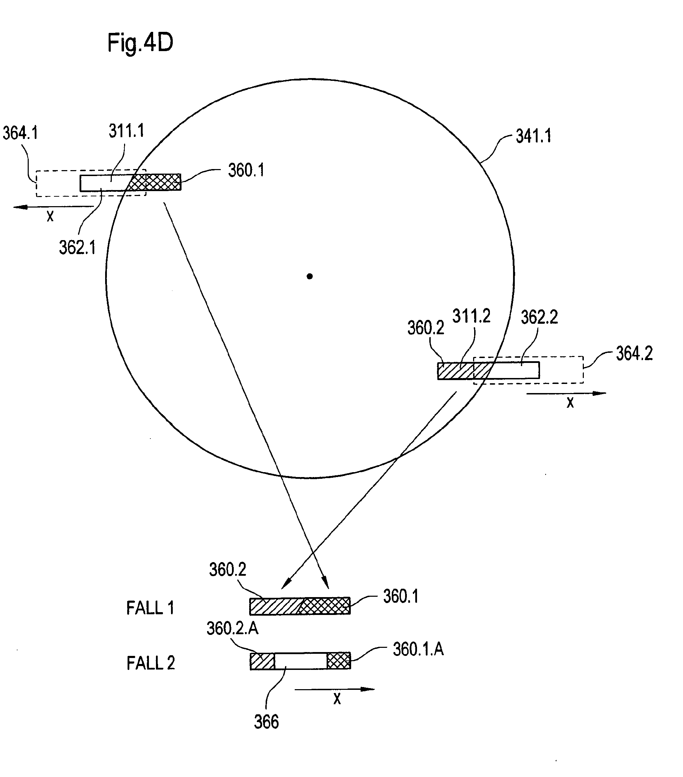

Dadurch ergibt sich eine variabel einstellbare Ausleuchtung in der Feldebene. Dies ist näher in Figur 4d dargestellt.

In Figur 4d ist dargestellt, wie die Ausleuchtung in x-Richtung eingestellt werden kann. Um dies zu veranschaulichen sind in einer Ausleuchtung einer Außengrenze 341.1 zwei nur teilweise ausgeleuchtete Feldrasterelemente bzw. Feldfacetten 311.1 und 311.2 dargestellt. Die teilweise ausgeleuchteten Feldrasterelemente umfassen einen ausgeleuchteten Teil 360.1 für das Feldrasterelement 311.1 und 360.2 für das Feldrasterelement 311.2 sowie einen nicht ausgeleuchteten Bereich 362.1 für das Feldrasterelement 311.1 und 362.2 für das Feldrasterelement 311.2. Werden die teilweise ausgeleuchteten Feldrasterelemente 311.1, 311.2 in die Feldebene abgebildet, so überlagern sich die ausgeleuchteten Teilbereiche 360.1 und 360.2 und ergänzen sich zu einem gesamten ausgeleuchteten Feld wie in Fall 1 in Figur 4d dargestellt. Durch die Blenden 364.2 und 364.1 kann die Größe des ausgeleuchteten Bereiches der Feldfacette 311.1 und 311.2 eingestellt werden. Werden diese Feldfacetten dann in der Feldebene überlagert, so ergibt sich bei der strichpunktierten Einstellung der Blenden 364.1 und 364.2 die in Fall 2 in Figur 4d dargestellte Ausleuchtung. Wie zu entnehmen wird bei dem Feld nur noch der Bereich 360.1.A und 360.2.A ausgeleuchtet. Der Bereich 366 ist nicht ausgeleuchtet. Wie aus Fig. 4d deutlich hervorgeht wird durch Verschieben der Blenden 364.1 und 364.2 in x-Richtung es ermöglicht aus dem ausgeleuchteten Feld gezielt Energie herauszunehmen je nach Feldhöhe bzw. Energie in das Feld hinein zu geben.

Diese Einstellbarkeit bedingt, dass die Uniformität der Ausleuchtung, d. h. die Variation der Uniformität in Abhängigkeit von der Feldhöhe beeinflusst werden kann.

Durch die Möglichkeit die Uniformität in Abhängigkeit von der Feldhöhe mit Hilfe der in Figur 4a und 4d gezeigte Einstelleinrichtung in Form von Blenden in Abhängigkeit von der Feldhöhe zu beeinflussen, ergibt sich die Möglichkeit, bei plötzlichen Änderungen der Ausleuchtung und damit der Uniformität in der Feldebene, beispielsweise aufgrund von Schwankungen sowohl im räumlichen Ort wie in der zeitlichen Intensitätsabgabe der Lichtquelle oder beim Tausch optischer Komponenten, wie beispielsweise eines Kollektors oder einer Lichtquelle, mit Hilfe der Blenden 364.2 und 364.1 die Uniformität der Ausleuchtung so einzustellen, dass der Uniformitätsfehler unterhalb eines bestimmten Wertes liegt. Insbesondere kann damit die Feldausleuchtung so beeinflusst werden, dass ein Uniformitätsfehler $\Delta$ SE $\leq$ 10%, bevorzugt $\leq$ 5%, ganz bevorzugt $\leq$ 2% erreicht wird. Die Einstellbarkeit ermöglicht also eine Art Regelsystem, in Abhängigkeit von der Uniformität der Ausleuchtung in der Feldebene beispielsweise mit Hilfe der Blenden der Einstellvorrichtung die Uniformität so einstellt, dass ein vorgegebener Uniformitätsfehler unterschritten wird.

So kann sich beispielsweise die Uniformität und damit der Uniformitätsfehler nach Tausch der Lichtquelle ändern. Mit Hilfe der Blenden 364.1, 364.2 ist es dann möglich die ausgeleuchteten Bereiche der teilweise ausgeleuchteten Feldfacetten einzustellen und somit für den Uniformitätsfehler einen vorgegeben Wert zu erreichen.

Auch eine Nachstellung im Betrieb wäre möglich. Hierzu wird nach einer gewissen Anzahl von Belichtungen ein Sensor in die Feldebene oder in die Bildebene des Projektionsobjektives eingebracht, beispielsweise eingeschwenkt und die Ausleuchtung in dieser Ebene gemessen. Aus dieser Messung kann dann der Uniformitätsfehler bestimmt werden und eine entsprechende Einstellung zur Korrektur durchgeführt werden. Dies ermöglicht es beispielsweise bei degradierenden Schichten, z. B. auf dem Kollektor oder den Spiegeln oder aber bei Schwankungen der Lichtquelle die Uniformität so nachzuregulieren, dass ein gewisser Uniformitätsfehler nicht überschritten wird. Wird der Sensor in die Bildebene, d.h. in die Waferebene eingebracht, so kann der Uniformtätsfehler des Projektionsobjektives mitbestimmt werden.

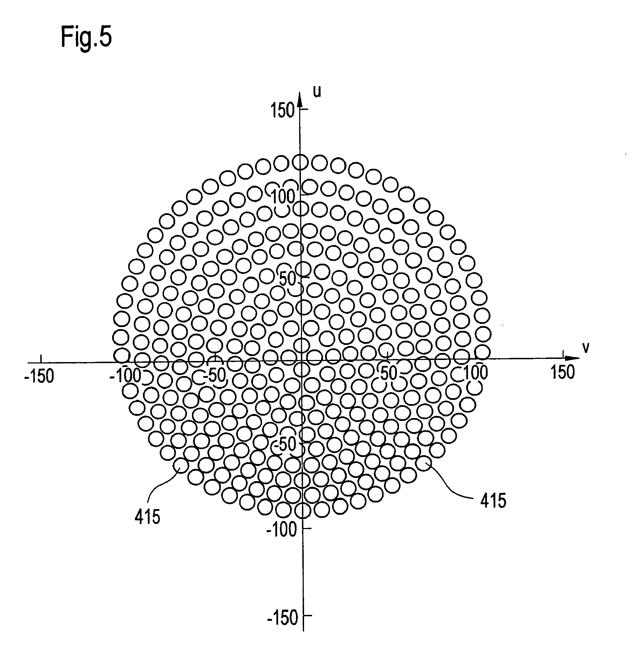

In Fig. 5 wird eine erste Anordnung von Pupillenrasterelementen 415 auf dem zweiten facettierten optischen Element, das in Figur 3 mit 104 bezeichnet ist, dargestellt. Des Weiteren eingezeichnet ist ein u-v-z Koordinatensystem. Bevorzugt entspricht die Gestalt der Pupillerasterelemente 415 der Gestalt der sekundären Lichtquellen in der Ebene, in der das zweite optische Element mit Pupillenrasterelementen angeordnet ist.

In Fig. 6 ist ein ringförmiges Feld, wie es in der Feldebene 129 des Beleuchtungssystems für ein Ringfeldscanner gemäß Fig. 3 ausgebildet wird, dargestellt.

Das Feld 131 weist im Gegensatz zu dem schematisch in Fig. 4d dargestellten Rechteckfeld eine ringförmige Gestalt auf. In Fig. 6 eingezeichnet ist ein x-y-Koordinatensystem sowie der zentrale Feldpunkt Z des Feldes 131.. Hierbei bezeichnet die y-Richtung die sog. Scanrichtung falls das Beleuchtungssystem in einem als Ringfeldscanner ausgebildeten Scanning-Mikrolithographie-Projektionssystem eingesetzt wird, und die x-Richtung die Richtung, die senkrecht auf der Scan-Richtung steht. In Abhängigkeit von der x-Position, die auch als sog. Feldhöhe bezeichnet wird, können scanintegrierte Größen, d.h. Größen die entlang der y-Achse integriert werden, bestimmt werden. Viele Größen einer Beleuchtung sind feldabhängige Größen. Eine derartige feldabhängige Größe ist beispielsweise die sog. Scanning-Energie (SE), deren Größe je nach Feldhöhe x unterschiedlich ausfällt, d.h. die Scanning-Energie ist eine Funktion der Feldhöhe. Generell gilt

$$SE\ (x) = \int E(x,y)dy,$$

wobei

E die Intensitätsverteilung in der x-y-Feldebene abhängig von x und y ist. Für eine uniforme, d.h. gleichmäßige Ausleuchtung und andere charakteristische Größen des Beleuchtungssystemes wie die Elliptizität und die Telezentrie die gleichfalls von der Feldhöhe x abhängen, ist es von Vorteil, wenn diese Größen im wesentlichen über der gesamten Feldhöhe x einen im Wesentlichen gleichen Wert aufweisen und nur geringe Abweichungen auftreten.

Als Maß für die Uniformität der Scanning-energie in der Feldebene gilt die Variation der Scanningenergie über die Feldhöhe. Die Uniformität wird also durch nachfolgende Beziehung für den Uniformitätsfehler in Prozent beschrieben:

$$\Delta SE = \frac{SE_{max} - SE_{min}}{SE_{max} + SE_{min}}\ x\ 100\ [\%]$$

Wobei $\Delta$SE der Uniformitätsfehler bzw. die Variation der Scanning-Energie in % ist.

$SE_{Max}$: maximaler Wert der Scanning-Energie

$SE_{Mm}$: minimaler Wert der Scanning-Energie

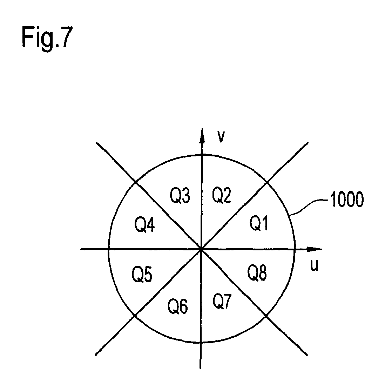

Unter Elliptizität wird in vorliegender Anmeldung die Gewichtung der Energieverteilung in der Austrittspupille bzw. in der Austrittspupillenebene bezeichnet. Wird in der Austrittspupillenebene 140 wie in Figur 7 dargestellt, ein Koordinatensystem in u,v z-Richtung definiert, so verteilt sich die Energie in der Austrittspupille 1000 über den Winkelbereich der Koordinaten u,v. In Figur 7 ist die Pupille in Winkelbereiche Q1,Q2,Q3,Q4,Q5,Q6,Q7,Q8 aufgeteilt. Der Energieinhalt in dem jeweiligen Winkelbereich ergibt sich dann durch Integration über den jeweiligen Winkelbereich. So bezeichnet bezeichnet beispielsweise I1 den Energieinhalt des Winkelbereiches Q1. Es gilt für I1 also:

$$I1 = \int_{Q1} E(u,v) \, dudv$$

wobei E(u,v) die Intensitätsverteilung in der Pupille ist.

Man bezeichnet als -45°/45°-Elliptizität nachfolgende Größe

$$E_{-45°/45°} = \frac{I1 + I2 + I5 + I6}{I3 + I4 + I7 + I8}$$

und als 0°/90°-Elliptizität die nachfolgende Größe:

$$E_{0°/90°} = \frac{I1 + I8 + I4 + I5}{I2 + I3 + I6 + I7}$$

Hierbei sind I1,I2,I3,I4,I5,I6,I7,I8 der Energieinhalt wie oben definiert in den jeweiligen wie in Figur 7 dargestellten Winkelbereichen Q1, Q2, Q3, Q4, Q5, Q6, Q7, Q8 der Austrittspupille.

Da sich für jeden Feldpunkt des ausgeleuchteten Feldes in der Feldebene eine andere Austrittspupille ergibt, ist die Pupille und damit die Elliptizität abhängig von der Position im Feld. Ein ringförmiges Feld, wie es in der Mikrolithographie verwendet wird, ist in Figur 6 gezeigt. Das Feld wird durch ein x-, y-, z-Koordinatensystem in der Feldebene 129 beschrieben. Da die Pupille vom Feldpunkt abhängig ist, ist sie von der x-, y-Position im Feld abhängig, wobei die y-Richtung, die Scan-Richtung ist.

Des Weiteren ist in jedem Feldpunkt des ausgeleuchteten Feldes ein Schwerstrahl eines Lichtbüschels definiert. Der Schwerstrahl ist die energiegewichtete Richtung des von einem Feldpunkt ausgehenden Lichtbüschels.

Die Abweichung des Schwerstrahls vom Hauptstrahl CR ist der sogenannte Telezentriefehler. Für den Telezentriefehler gilt:

$$\vec{s}(x,y) = \frac{1}{N} \int dudv \begin{pmatrix} u \\ v \end{pmatrix} E(u,v,x,y), \quad N = \int dudv E(u,v,x,y)$$

E(u,v,x,y) ist die Energieverteilung in Abhängigkeit von den Feldkoordinaten x,y in der Feldebene 129 und den Pupillenkoordinaten u. v. in der Austrittspupillenebene 140.

Generell ist jedem Feldpunkt eines Feldes in der Feldebene 129 eine Austrittspupille in der Austrittspupillenebene 140 des Beleuchtungssystems gemäß Fig. 3 zugeordnet. In der dem jeweiligen Feldpunkt zugeordneten Austrittspupille wird eine Vielzahl tertiärer Lichtquellen, die auch als Subpupillen bezeichnet werden, ausgebildet.

In Fig. 8 ist für eine Feldhöhe von x= -52 mm eines bogenförmigen Feldes, wie in Fig. 6 dargestellt, beispielhaft eine scanintegrierte Pupille gezeigt.

Die scanintegrierte Pupille ergibt sich durch Integration über die Energieverteilung E(u,v,x,y) entlang des Scanweges d.h. entlang der y-Richtung. Die scanintegrierte Pupille ist somit:

$$E(u,v,x) = \int dy \, E(u,v,x,y)$$

Integration über die Koordinaten u,v der scanintegrierten Pupille ergibt dann die Intensitäten I1, I2, I3, I4, I5, I6, I7, I8 wie oben definiert und damit die -45°/45° oder die 0°/90° Elliptizität in Abhängigkeit von der Feldhöhe x, beispielsweise von x=-52 mm.

Wie aus Fig. 8 zu erkennen, weist die Austrittspupille in der Austrittspupillenebene einzelne Subpupillen, nämlich tertiäre Lichtquellen 500 auf. Wie aus Fig. 8 zu erkennen ist, beinhalten die einzelnen Subpupillen 500 unterschiedliche Energien und weisen eine Feinstruktur auf, die von den Kollektorschalen bzw. Kollektorspeichen eines beispielsweise genesteten Kollektors beispielsweise des in Fig 3 gezeigten genesteten Kollektors 103 herrühren. Die unterschiedlichen Intensitätswerte der Subpupillen 500 sind Folge der nicht vollständigen Ausleuchtung einzelner Feldrasterelemente bzw. Feldfacetten des ersten facettierten optischen Elementes 102. Wie zuvor beschrieben sind einzelne Feldrasterelemente nicht vollständig ausgeleuchtet, andere dagegen vollständig. Der energetische Unterschied der nicht vollständig und der vollständig ausgeleuchteten Feldrasterelemente bewirkt, dass die Elliptizität, beispielsweise die -45°/45° oder die 0°/90° Elliptizität, in der Austrittspupille sowie die Telezentrie in Abhängigkeit von der Feldhöhe, d.h. entlang der x-Koordinate, stark variiert, wenn nicht Maßnahmen getroffen werden, um eine möglichst gleichförmige Elliptizität über der Feldhöhe, d.h. entlang der x-Koordinate, sowie Telezentrie sicherzustellen.

Eine möglichst gleichförmige Elliptizität in der Austrittspupille in Abhängigkeit von der Feldhöhe bzw. Telezentrie kann erreicht werden, wenn man ganz bestimmte Zuordnungen von Feldfacetten bzw. Feldrasterelementen zu Pupillenfacetten bzw. Pupillenrasterelementen vornimmt.

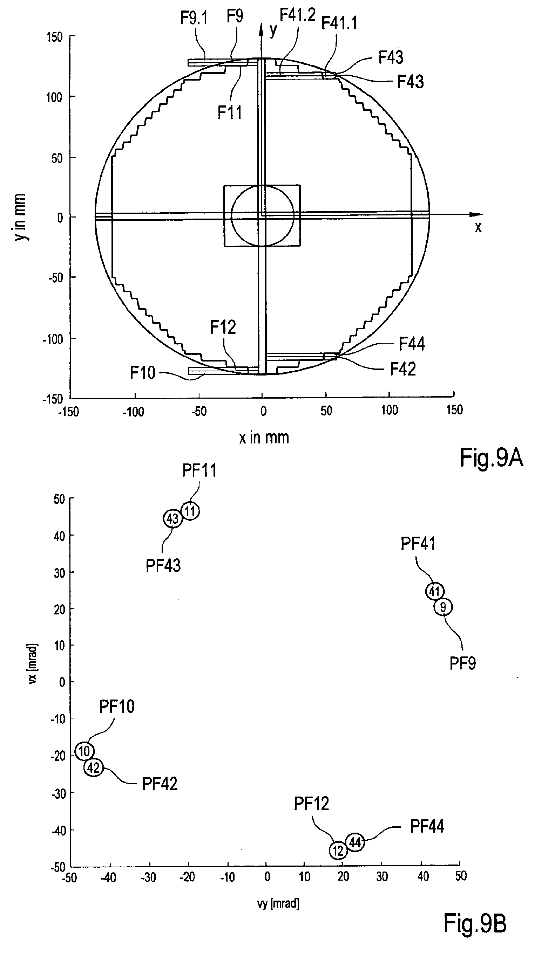

Eine Zuordnungsregel für ein Beispiel von insgesamt 8 Feld- und Pupillenfacetten, die dies gewährleistet, ist in den Figuren 9a-9b dargestellt. In Figur 9b dargestellt sind Feldfacetten F9, F10, F11, F12 sowie F41, F42, F43, und F44. In Figur 9 dargestellt sind die zugeordneten Pupillenfacetten, die zu der Ausleuchtung in der Austrittspupille führen.

Aus Figur 9a und 9b kann man erkennen, dass der Telezentriefehler über das gesamte Feld minimiert wird, wenn einander gegenüberliegende Feldfacetten, bspw. die Feldfacetten F9 und F10 in Fig. 9a punktsymmetrischen Subpupillen in die Austrittspupille zugeordnet werden. Dies gilt auch für die einander gegenüber liegenden Facetten F11 und F12. In Fig. 9a ist ein facettiertes optisches Element mit Feldfacetten dargestellt und in Fig. 9b das zugeordnete facettierte optische Element mit Pupillenfacetten PF9, PF10, PF11, PF12, PF41, PF42, PF43 und PF44. Die Lage der Pupillenfacetten wiederum bestimmt die Lage er Subpupillen in der Austrittspupille. Dies bedeutet, dass die Zuordnung von Feldfacetten zu den Pupillenfacetten bevorzugt so erfolgt, dass zur x-Achse spiegelsymmetrisch liegende Feldfacetten z.B. F9 und F10 bevorzugt denjenigen Pupillenfacetten zugeordnet werden, deren Bilder punktsymmetrisch in der Austrittspupille liegen (PF9 und PF10). Dies ist in der Regel deswegen vorteilhaft, weil spiegelsymmetrisch zur x-Achse angeordnete Feldfacetten bei einer kreisförmigen Ausleuchtung im Regelfall ein weitgehend identisches Intensitätsprofil aufweisen.

Um die Elliptizitätsfehler gering zu halten, sind jeweils zwei Paar Facettenspiegeln, die benachbart liegen, also die Feldfacetten F9, F11 und F10, F12, um 90° versetzten Pupillenfacettenspiegeln PF9, PF10, PF11, PF12 zugeordnet. Feldfacetten die einen ähnlichen Intensitätsverlauf zeigen, liegen in der Pupille somit in um 90° versetzten Oktanten.

Im Idealfall gilt I1(x)=I3(x)=I5(x)=I7(x), so dass

$$E_{-45°/45°}(x) = \frac{I1(x) + I5(x)}{I3(x) + I7(x)} = 1$$

die Ellipzität dieser vier Kanäle ist somit konstant über das Feld gleich 1.

Facetten, die sich in ihrer Ausleuchtung ergänzen, bspw. die Facetten F9, F41 werden solchen Pupillenfacetten PF9, PF41 zugeordnet, dass die den Feldfacetten PF9, PF41 zugeordneten Subpupillen in der Austrittspupille benachbart zueinander liegen.

Eine derartige Zuordnung hat den Vorteil, dass eine gleichmäßige Ausleuchtung über die Austrittspupille erzielt wird. Ergänzen sich die Feldfacetten F9 und F41, so bedeutet dies, dass der Teilbereich F9.1 der bei der Feldfacette F9 dunkel erscheint, bei der Feldfacette F41 der helle Bereich F41.2 ist. Der dunkle Bereich F9.1 führt dazu, dass im Feldbereich, der F9.1 zugeordnet ist, die zugehörige Subpupille dunkel ist. Die der Pupillenfacette PF41 zugeordnete Subpupille ist dann entsprechend in diesem Feldbereich hell ausgeleuchtet. Wenn die Pupillenfacette PF9 und PF41 nebeneinander liegen ist die Auswirkung eines Hell-Dunkel-Wechsels bzw. Unterschiedes über das Feld minimal.

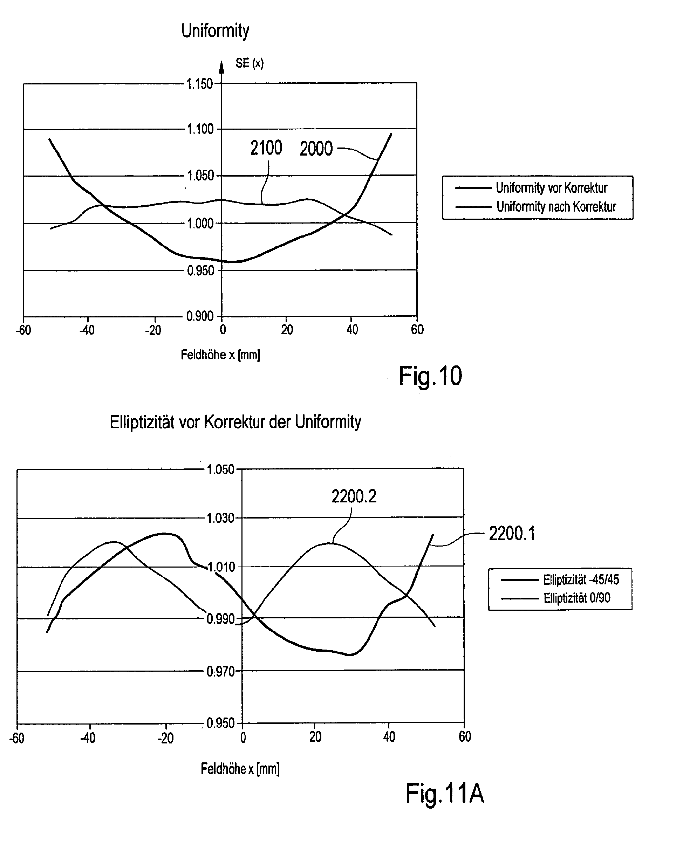

Mit Hilfe der einzelnen Blenden zur Steuerung der Ausleuchtung der einzelnen Feldfacetten kann die Uniformität der Ausleuchtung in der Feldebene des Beleuchtungssystems beeinflusst werden. Insbesondere kann beispielsweise die Uniformität der Ausleuchtung so eingestellt werden, dass $\Delta SE(x) \leq 2\%$ ist. Das Ergebnis der Einstellung der Uniformität mit Hilfe von Blenden ist in Fig. 10 veranschaulicht. Während ohne Korrektur der Uniformitätsfehler einen Wert $\Delta SE \geq 10\%$ aufweist, ist der Uniformitätsfehler $\Delta SE \leq 5\%$. Insbesondere ist der größte Wert $SE_{Max}$ der scan-integrierten Energie SE(x) nach der Korrektur ungefähr 1,02 und der kleinste Wert $SE(x)_{Min}$ ungefähr 1,0, so dass $\Delta SE \approx 2\%$ nach

der Korrektur der Feldausleuchtung durch die Blenden ist.

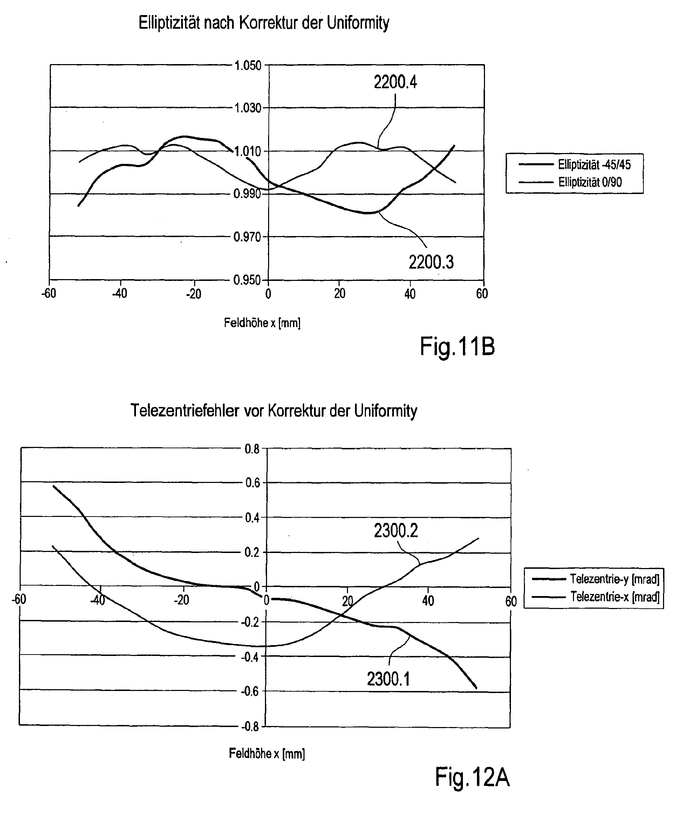

Den Effekt der Einstellung der Uniformität mit Hilfe der Blenden wie beschrieben auf den Verlauf der Elliptizität in Abhängigkeit von der Feldhöhe, d.h. der x-Koordinate ist für die -45°/45° oder die 0°/90° Elliptizität in den Figuren 11a und 11 b gezeigt. Figur 11a zeigt die -45°2/45°-Elliptizität 2200.1 oder die 0°/90° Elliptizität 2200.2 für ein Beleuchtungssystem gemäß Figur 3 mit einer Kanalzuordnung der Feld- zu den Pupillenfacetten wie zuvor beschrieben. In Abhängigkeit von der Feldhöhe schwankt die -45°/45°-Elliptizität zwischen 0,97 und 1,03 und die 0°/90°-Elliptizität zwischen 0,97 und 1,03. Figur 11 b zeigt den Verlauf der -45°/45° 2200.3 bzw. den Verlauf der 0°/90° Elliptizität 2200.4 nachdem die Uniformität des Feldes wie in Figur 10 gezeigt, korrigiert wurde. Wie in Fig. 11 b zu erkennen, ist sowohl die -45°/45° Elliptizität wie auch die 0°/90° Elliptizität bei der Korrektur der Uniformität nur innerhalb des erlaubten Fehlerbereiches verändert worden. Die -45°/45° Elliptizität schwankt zwischen 0,990 und 1,01 und die 0°/90° Elliptizität zwischen 0,99 und 1,02 in Abhängigkeit von der Feldhöhe.

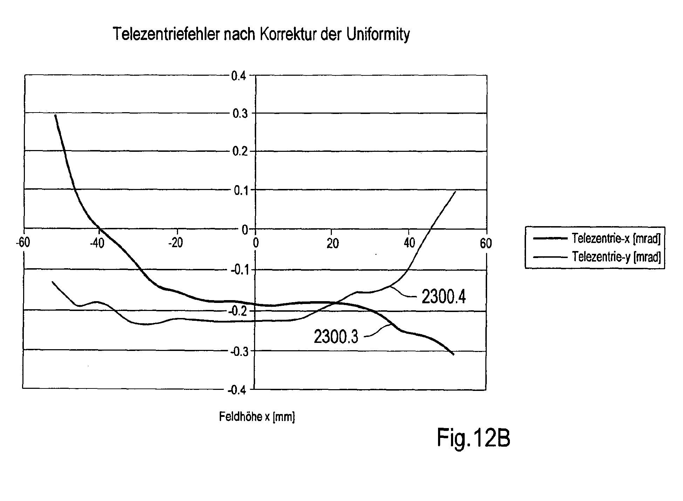

In den Figuren 12a und 12b wird der Telezentriefehler des Systems in Abhängigkeit von der Feldhöhe x für ein System gemäß Figur 3 mit der zuvor gegebenen Zuordnungsregel in x-Richtung und y-Richtung für die jeweilige zur Feldhöhe gehörende Austrittspupille gezeigt.

Der Telezentriefehler beträgt in x-Richtung und in y-Richtung weniger als 1 mrad. Der Verlauf in x-Richtung ist in Fig. 12a mit 2300.1 gekennzeichnet, der in y-Richtung mit 2300.2 vor der Korrektur der Uniformität. In Figur 12b ist der Telezentriefehler nach Korrektur der Uniformität dargestellt. Wie aus Figur 12b zu entnehmen, beträgt der Telezentriefehler über dem Feld weniger als $\pm$ 0,2mrad sowohl in x- wie in y-Richtung.

Mit der vorliegenden Erfindung wird somit erstmals ein Beleuchtungssystem angegeben, mit dem die Uniformität der Ausleuchtung in der Feldebene, scanintegrierte Elliptizitätsfehler sowie Telezentriefehler eines Systems eingestellt werden können und ein großer Anteil des Lichtes in der Ebene, in der das erste facettierte Element angeordnet ist zur Ausleuchtung der Feldebene genutzt wird.

## Patentansprüche

1. Beleuchtungssystem für eine Projektionsbelichtungsanlage mit Wellenlängen $\leq$ 193nm, bevorzugt $\leq$ 126 nm, besonders bevorzugt Wellenlängen $\leq$ 30 nm, insbesondere im Bereich 10 nm bis 30 nm wobei das Licht einer Lichtquelle in einem Lichtweg in eine Feldebene (129) geleitet wird, umfassend

   ein optisches Element (102) mit einer Vielzahl von Feldrasterelementen (309), das in einer Ebene (150) in einem Lichtweg von der Lichtquelle (101) zur Feldebene (129) nach der Lichtquelle (101) angeordnet ist, wobei in der Ebene (150) eine Ausleuchtung zur Verfügung gestellt wird und wenigstens ein Feldrasterelement der Vielzahl von Feldrasterelementen (309) in der Ebene (150) nur in einem ersten Teilbereich (360.1, 360.2) ausgeleuchtet wird und einem zweiten Teilbereich (362.1, 362.2) nicht ausgeleuchtet wird und eine Vorrichtung zur Einstellung der Größe des ersten und des zweiten Teilbereichs des Feldrasterelementes (311.1, 311.2) vorhanden ist, wobei mit der Vorrichtung eine Uniformität einer Feldausleuchtung eines Feldes (131) in der Feldebene (129) eingestellt werden kann.

2. Beleuchtungssystem nach Anspruch 1, **dadurch gekennzeichnet, dass** die Ausleuchtung in der Ebene (150) zu mehr als 70%, insbesondere zu mehr als 80%, ganz bevorzugt mehr als 90% von den in der Ebene (150) angeordneten Feldrasterelementen (309) aufgenommen wird.

3. Beleuchtungssystem nach einem der Ansprüche 1 bis 2, **dadurch gekennzeichnet, dass** die Feldausleuchtung einen Uniformitätsfehler $\Delta SE$ $\Delta SE \leq$ 10%, bevorzugt $\leq$ 5%, ganz bevorzugt $\leq$ 2% aufweist.

4. Beleuchtungssystem nach einem der Ansprüche 1 bis 3, wobei das Feld (131) eine erste Form aufweist und die Feldrasterelemente (309) eine zweite Form und die erste Form weitgehend mit der zweiten Form übereinstimmt.

5. Beleuchtungssystem nach Anspruch 4, wobei die Feldrasterelemente (309) eine bogenförmige Form aufweisen.

6. Beleuchtungssystem nach einem der Ansprüche 1 bis 5, wobei die Feldrasterelemente (309) in Spalten (343.1, 343.2, 343.3, 343.4) und Reihen (345) angeordnet sind, wobei die Reihen nicht gegeneinander verschoben sind.

7. Beleuchtungssystem nach einem der Ansprüche 1 bis 6, wobei die Feldrasterelemente in Spalten und Reihen angeordnet sind und mehrere Feldrasterelemente zu Blöcken (347) zusammengefasst sind.

8. Beleuchtungssystem nach einem der Ansprüche 1 bis 7, wobei die Vorrichtung zur Einstellung der Ausleuchtung wenigstens eine Blende (357) umfasst.

9. Beleuchtungssystem nach Anspruch 8, wobei die Blende (357) in der Ebene (150) beweglich ausgebildet ist.

10. Beleuchtungssystem nach Anspruch 9, wobei in der Ebene (150) eine Scanrichtung zur Verfügung gestellt wird und die Blende (357) im Wesentlichen senkrecht zur Scanrichtung beweglich ausgebildet ist.

11. Beleuchtungssystem nach einem der Ansprüche 8 bis 10, wobei die Blende (357) einem oder mehreren Feldrasterelementen (309) zugeordnet ist.

12. Beleuchtungssystem nach einem der Ansprüche 1 bis 5, wobei die Vorrichtung zur Einstellung der Ausleuchtung eine oder Kombination mehrerer der nachfolgenden Vorrichtungen umfasst:

- eine Vorrichtung zur Verformung und/oder Verkippung eines optischen Elementes, welches im Lichtweg von der Lichtquelle zur Feldebene angeordnet ist.
- eine Vorrichtung zum Verschieben des optischen Elementes (102) in der Ebene (150)
- eine Vorrichtung zum Verfahren wenigstens einer einem Feldrasterelement zugeordneten Blende.

13. Beleuchtungssystem für eine Projektionsbelichtungsanlage für Wellenlängen ≤ 193 nm, bevorzugt ≤ 126 nm, besonders bevorzugt Wellenlängen ≤ 30 nm, insbesondere im Bereich 10 bis 30 nm wobei Licht einer Lichtquelle in eine Feldebene geleitet wird, umfassend ein optisches Element (102) mit einer Vielzahl von Feldrasterelementen (309), das in einem Lichtweg von der Lichtquelle zur Feldebene nach der Lichtquelle in einer Ebene (150) angeordnet ist, wobei in der Ebene (150) eine Ausleuchtung zur Verfügung gestellt wird und wenigstens ein Teil der Vielzahl von Feldrasterelementen in der Ebene nicht vollständig ausgeleuchtet wird, wobei die Feldrasterelemente, die nicht vollständig ausgeleuchtet werden, in der Ebene derart angeordnet sind, dass eine Feldausleuchtung in einer Feldebene (129) mit einem Uniformitätsfehler $\Delta SE$ zur Verfügung gestellt wird und der Uniformitätsfehler $\Delta SE \leq 10\%$, bevorzugt ≤ 5%, ganz bevorzugt ≤ 2% ist und wobei je einem Feldrasterelement (20) ein Pupillenrasterelement (22) zugeordnet ist und ein Lichtkanal zwischen dem Feldrasterelement und dem zugeordneten Pupillenrasterelement ausgebildet wird, derart, dass eine Austrittspupillenausleuchtung in einer Austrittspupille des Beleuchtungssystem eine scanintegrierte Elliptizität im Bereich 1 ± 0,1, bevorzugt 1 ± 0,05, insbesondere 1 ± 0,02 aufweist.

14. Beleuchtungssystem nach Anspruch 13, wobei das Feld eine erste Form aufweist und die Feldrasterelemente eine zweite Form und die erste Form weitgehend mit der zweiten Form übereinstimmt.

15. Beleuchtungssystem nach Anspruch 14, wobei die Feldrasterelemente eine bogenförmige Form aufweisen.

16. Beleuchtungssystem nach einem der Ansprüche 13 bis 15, wobei die Feldrasterelemente in Spalten und Reihen angeordnet sind, wobei die Reihen gegeneinander verschoben sind.

17. Beleuchtungssystem nach einem der Ansprüche 13 bis 15, wobei die Feldrasterelemente in Spalten und Reihen angeordnet sind und mehrere Feldrasterelemente zu Blöcken zusammengefasst sind.

18. Beleuchtungssystem nach einem der Ansprüche 1 bis 17, wobei die Ausleuchtung in der Ebene (150) eine kreisförmige oder annulare Form aufweist.

19. Beleuchtungssystem nach einem der Ansprüche 1 bis 18, wobei das optische Element ein erstes optisches Element (102) ist und im Lichtweg der Lichtquelle (101) zur Feldebene (129) nach dem ersten optischen Element (102) ein zweites optisches Element (104) mit einer Vielzahl von Pupillenrasterelementen angeordnet ist.

20. Beleuchtungssystem nach Anspruch 19, wobei je einem Feldrasterelement (20) ein Pupillenrasterelement (22) zugeordnet ist und ein Lichtstrahl zwischen dem Feldrasterelement und dem zugeordneten Pupillenrasterelement ausgebildet wird, derart, dass eine Austrittspupillenausleuchtung in einer Austrittspupillenebene des Beleuchtungssystem einen Telezentriefehler von ≤ 2,5mrad, insbesondere ≤ 1,5mrad, ganz besonders ≤ 0,5mrad aufweist.

21. Projektionsbelichtungsanlage umfassend
ein Beleuchtungssystem gemäß einem der Ansprüche 1 bis 20
ein Projektionsobjektiv zur Abbildung eines vom Beleuchtungssystem in der Feldebene ausgeleuchteten Objektes in eine Bildebene.

22. Verfahren zur Einstellung der Uniformität, Telezentrie und Elliptizität eines Beleuchtungssystems mit einer Ausleuchtung in einer Ebene (150), in der ein erstes optisches Element mit Feldrasterelementen angeordnet ist und einer Feldausleuchtung eines Feldes in einer Feldebene sowie einer Pupillenausleuchtung in einer Austrittspupille, umfassend die Schritte: die Ausleuchtung in der Ebene (150) mit Feldrasterelementen wird mit einer Vorrichtung zur Einstellung der Ausleuchtung derart eingestellt, dass die Uniformität der Feldausleuchtung des Feldes einen Uniformitätsfehler $\leq$ 10%, insbesondere $\leq$ 5%, ganz bevorzugt $\leq$ 2% aufweist. jedem Feldrasterelement wird ein Pupillenrasterelement eines zweiten optischen Elementes ergebend einen Lichtkanal zugeordnet, wobei die Zuordnung derart erfolgt, dass in einer Austrittspupillenebene eine Pupillenausleuchtung mit einem Telezentriefehler $\leq$ 2mrad, bevorzugt $\leq$ 1,5mrad, insbesondere $\leq$ 0,5mrad vorliegt und/oder eine Elliptizität von 1 $\pm$ 0,1, insbesondere 1 $\pm$ 0,05, bevorzugt 1 $\pm$ 0,02 zur Verfügung gestellt wird.

**23.** Verfahren gemäß Anspruch 22, wobei die Vorrichtung zur Einstellung der Ausleuchtung Blenden aufweist, die den nicht vollständig ausgeleuchteten Feldrasterelementen zugeordnet sind, und das ausgeleuchtete Feld in der Ebene (150) eine Scanrichtung aufweist und die Blenden zur Einstellung der Uniformität in einer Richtung senkrecht zur Scanrichtung verfahren werden.

**24.** Verfahren gemäß Anspruch 22 oder 23, wobei die Vorrichtung zur Einstellung der Ausleuchtung eine Vorrichtung zur Verformung und/oder Verkippung eines optischen Elementes, welches im Lichtweg von der Lichtquelle zur Feldebene angeordnet ist, aufweist und zur Einstellung der Uniformität das optische Element verformt und/oder verkippt wird.

**25.** Verfahren nach einem der Ansprüche 22 bis 24, wobei die Feldrasterelemente auf einem Träger unter einem Kippwinkel angeordnet sind und durch Aktuatoren der Kippwinkel verändert und damit die Zuordnung von Feldrasterelementen zu Pupillenrasterelementen eingestellt wird.

**26.** Verfahren zur Herstellung mikroelektronischer Bauteile, umfassend die nachfolgenden Schritte:

es wird mit Hilfe einer Projektionsbelichtungsanlage gemäß Anspruch 21 eine strukturierte Maske auf eine lichtempfindliche Schicht, die sich in einer Bildebene eines Projektionsobjektives befindet abgebildet;
die strukturierte Maske wird entwickelt, ergebend einen Teil des mikroelektronischen Bauteils oder des mikroelektronischen Bauteils selbst.

Fig.1

Fig.2A

Fig.2B

Fig.3

EP 1 884 831 A2

Fig.4A

Fig.4B

Fig.4C

# Fig.4D

Fig.5

## Fig.6

Fig.7

Fig.8

Fig.9A

Fig.9B

Uniformity

Feldhöhe x [mm]

Fig.10

Elliptizität vor Korrektur der Uniformity

Feldhöhe x [mm]

Fig.11A

Elliptizität nach Korrektur der Uniformity

Fig.11B

Telezentriefehler vor Korrektur der Uniformity

Fig.12A

Telezentriefehler nach Korrektur der Uniformity

Feldhöhe x [mm]

Fig.12B

**EP 1 884 831 A2**

IN DER BESCHREIBUNG AUFGEFÜHRTE DOKUMENTE

**In der Beschreibung aufgeführte Patentdokumente**

- US 6452661 B
- US 6198793 B
- US 6438199 B
- WO 200227401 A
- US 6771352 B
- EP 1354325 A

- WO 2005015314 A
- WO 0227401 A
- US 6400794 B
- US 6195201 B
- EP 1291721 A